# EUROPEAN PATENT SPECIFICATION

(11) **EP 4 207 285 B1**
(45) Date of publication and mention of the grant of the patent: **17.12.2025**
(21) Application number: 21218452.7
(22) Date of filing: 31.12.2021
(51) Int. Cl.: H10D 89/60

(54) **SEMICONDUCTOR DEVICE AND ESD PROTECTION DEVICE COMPRISING THE SAME**
HALBLEITERBAUELEMENT UND DIESES UMFASSENDE ESD-SCHUTZVORRICHTUNG
DISPOSITIF SEMICONDUCTEUR ET DISPOSITIF DE PROTECTION CONTRE LES DÉCHARGES ÉLECTROSTATIQUES LE COMPRENANT

(43) Date of publication of application: 05.07.2023
(73) Proprietor: Nexperia B.V., 6534 AB Nijmegen (NL)
(72) Inventor: Ritter, Hans-Martin, 22529 Hamburg (DE); Holland, Steffen, 22529 Hamburg (DE); Wynants, Jochen, 22529 Hamburg (DE)
(74) Representative: Pjanovic, Ilija

(56) References cited:
- US-A- 5 774 318
- US-A1- 2013 099 280
- US-A1- 2015 187 752
- US-A1- 2021 043 622
- US-B1- 7 071 514
- US-B2- 8 000 124

## Description

The present disclosure relates to a semiconductor device. More in particular, the present disclosure relates to a semiconductor device that is particularly useful for ESD protection purposes.

Electronic devices and circuits may be subject to electrostatic discharge (ESD) events, for example due to close contact between said device (or circuit) with a differently-charged object, or due to a breakdown of a dielectric between said device (or circuit) and said object, resulting in a sudden flow of electricity. Excessive currents due to a sudden discharge from an ESD event can cause significant and/or permanent damage to sensitive electronic devices.

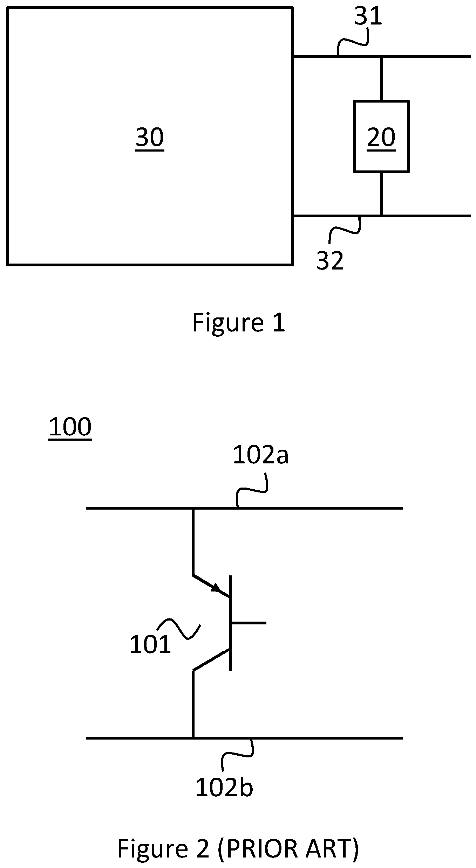

ESD protection devices can be used to prevent such damage to electronic devices or circuits. For example, a dedicated ESD protection device can be electrically connected in parallel to the electronic device to shunt the ESD current. An exemplary configuration is shown in Figure 1, in which an ESD protection device 20 is connected in between, for example, a signal line 31 and a rail line 32 of an electronic circuit 30, such as an integrated circuit (IC). Alternatively, ESD protection device 20 can be integrated with electronic circuit 30 into a single IC.

Generally, the ESD protection device or circuit has a relatively high current handling capability, and prevents or limits a current due to an ESD event from flowing through the sensitive electronic device(s) by allowing a substantial portion of said current to flow through the ESD protection device instead. At the same time, the ESD protection device should limit the voltages within the sensitive electronic device(s) or circuit(s) to sufficiently low levels to prevent damage to connected electronic device(s) or circuit(s) to be protected.

US8,000,124B2 discloses a symmetrical blocking transient voltage suppressing (TVS) circuit for suppressing a transient voltage.

A bipolar junction transistor (BJT) in an open-base configuration, such as shown in Figure 2, is frequently used in ESD protection devices. Here, the open-base configuration refers to the BJT being operated as a two-terminal device by leaving the base terminal of the BJT unconnected. Consequently, in operation, the base terminal of the BJT will be at a floating potential.

In Figure 2, a BJT 101 in open-base configuration is connected in between a first terminal 102a and a second terminal 102b. First and second terminal 102a, 102b may for example correspond to terminals of ESD protection device 20 as shown in Figure 1.

The operation of ESD protection device 20 is as follows. During an ESD event, a voltage across first and second terminal 102a, 102b rises rapidly. Since the base terminal of BJT 101 is at a floating potential, its electrical potential will self-adjust during the ESD event. In particular, during an ESD event, the base-collector junction of BJT 101 will be reverse-biased, such that initially substantially no current can flow through BJT 101. Therefore, the base-emitter junction also cannot be forward-biased at this stage. This condition is ensured by the self-adjusting electrical potential of the base. In other words, as the voltage across the first and second terminal 102a, 102b increases (i.e., due to the ESD event), the voltage across the base-collector junction will also increase.

After some time, the voltage across the base-collector junction will exceed a breakdown voltage of said junction, resulting in an avalanche breakdown of said junction. Since a current can now flow through the base-collector junction, the base-emitter junction will become forward-biased due to the self-adjusting electrical potential of the base, thereby enabling a current flow between first and second device terminal 102a, 102b through BJT 101. At this point, the emitter of BJT 101 starts injecting charge carriers into the base. Once the charge carriers from the emitter reach the base-collector avalanche region, BJT 101 will enter a 'snapback' mode, and the voltage across BJT 101 will decrease. At this point, BJT 101 switches to a low-Ohmic on-state, in which state a substantial current from the ESD event can be accommodated.

Here, it is noted that BJT 101 may be configured symmetrically, by arranging the 'emitter' and 'collector' region thereof such that they have a similar or identical dopant concentration. In the resulting BJT, said regions may function as either the 'emitter' or the 'collector', depending on a polarity of the ESD event.

In the known ESD protection device, thermal dissipation in the base-collector junction can be relatively large due to the large voltage drop across the base-collector junction during an ESD event, with respect to the forward-biased base-emitter junction. The thermal dissipation in the base-collector junction is therefore preferably minimized to increase a current handling capability of the ESD protection device.

A summary of aspects of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

The present invention concerns a device as defined in independent claim 1. Preferred embodiments are defined in the dependent claims.

According to an aspect of the present disclosure, a semiconductor device is provided. The semiconductor device comprises a semiconductor die having an electronic component integrated thereon. The electronic component comprises regions in the semiconductor die, the regions comprising: a first region of a first charge type configured to be electrically connected to a first device terminal; a second region of a second charge type arranged adjacent to and forming a first PN junction with the first region; a third region of the first charge type arranged adjacent to and forming a second PN junction with the second region, the third region being spaced apart from the first region by said second region and being configured to be electrically connected to a second device terminal; and a fourth region of the first charge type arranged adjacent to and forming a third PN junction with the second region, the fourth region being spaced apart from the first region and third region by said second region.

The semiconductor device further comprises an electronic unit configured to be electrically connected between the first device terminal, the second device terminal and the fourth region. During operation, the electronic unit is configured to provide a first current path between the fourth region and the first device terminal or a second current path between the fourth region and the second device terminal, in dependence of a polarity of a voltage across the first device terminal and the second device terminal.

The first, second and third region may together effectively operate as an open base transistor. However, the fourth region provides the electronic component with an additional region that, due to the electronic unit steering a current to or from said region, effectively acts as an additional 'collector' region regardless of the polarity of the voltage across the first and second device terminal. As such, the current handling capability of the semiconductor device can be effectively increased. In addition, electrical symmetry can be maintained with respect to the first and second terminal.

In particular, the fourth region functions as an open base transistor together with the first region and the second region, and functions as another open base transistor together with the second region and the third region. When any of the open base transistors enter the snapback mode due to a voltage across the semiconductor device, for example during an ESD event, a current will flow through the second region. Since the second region forms a 'base' region for each of the abovementioned open base transistor structures, this current flow effectively forms a base current for another one of the open base transistors mentioned above. The base current enables another current flow through one of the other open base transistors.

For example, an ESD event may occur with a positive polarity at the first device terminal with respect to the second device terminal. As such, a current may flow from the first device terminal to the second device terminal via at least one of the open base transistor structures formed by the first through fourth regions due to a breakdown of its corresponding base-collector junction. For example, the breakdown occurs in the open base transistor formed by the first, second and third region. In that case, the current flow through the second region due to this breakdown effectively forms a base current for the open base transistor structure formed by the second region, fourth region and one of the first and third region, the latter depending on the polarity of the voltage across the semiconductor device and the charge type of the regions. This base current enables another current flow from the first device terminal to the second device terminal via the third PN junction and the electronic unit. In this example, the third PN junction is a base-collector junction of the open base transistor formed by the second region, fourth region and one of the first and third region.

On the other hand, if the breakdown occurs at the base-collector junction of the open base transistor formed by the second region, fourth region and one of the first and third region, then the resulting current flow may effectively form a base current for the open base transistor formed by the first, second and third region. As such, another current can flow between the first and second device terminal, through the first through third regions.

In so far as the first charge type corresponds to an n-type doping, the first current path and the second current path extend from the first device terminal and the second device terminal, respectively, towards the fourth region. Alternatively, in so far as the first charge type corresponds to a p-type doping, the first current path and the second current path extend from the fourth region to the first device terminal and the second device terminal, respectively.

The electronic unit may comprise further regions comprised in the semiconductor die or one or more further semiconductor dies on which said electronic unit is integrated. The further regions may comprise: a first further region of the first charge type; a second further region of the second charge type arranged adjacent to and forming a first further PN junction with the first further region, the second further region being configured to be electrically connected to the first device terminal; a third further region of the first charge type; and a fourth further region of the second charge type arranged adjacent to and forming a second further PN junction with the third further region, the fourth further region being configured to be electrically connected to the second device terminal. The first further region and the second further region may be comprised in the semiconductor die or in a first further semiconductor die. Furthermore, the third further region and the fourth further region may be comprised in the semiconductor die, the first further semiconductor die or a second further semiconductor die. The first current path may extend through the first further region and the second further region, and the second current path may extend through the third further region and the fourth further region.

In a further embodiment, the first further region and the third further region may each be electrically connected to the fourth region. Furthermore, the first further region and the second further region may together form a first diode, and the third further region and the fourth further region may together form a second diode.

In so far as the first through fourth further regions are all comprised in the semiconductor die or on the first further semiconductor die, the first further region and the third further region may be adjacently arranged and may form a single further region.

In a further embodiment, the single further region may be electrically connected to the fourth region. Furthermore, the first further region, the second further region, the third further region and the fourth further region may together form a bipolar junction transistor, BJT.

The further regions may further comprise a fifth further region of the second charge type arranged adjacent to and forming a third further PN junction with the single further region. The fifth further region may be electrically connected to the fourth region and may be comprised in the semiconductor die or the first further semiconductor die. Furthermore, the first current path and the second current path may each additionally extend through the fifth further region.

In so far as the first through fifth regions are all comprised in the semiconductor die, the fourth region may be arranged adjacent to and may form an intermediate PN junction with the fifth further region. Optionally, the fifth further region and the second region are adjacently arranged to together form a contiguous region, or the fourth region and the single further region are adjacently arranged to together form a contiguous region.

In so far as the first through fifth further regions are all comprised in the first further semiconductor die, the semiconductor may comprise a first back contact electrically connected to the fourth region, and the first further semiconductor die may comprise a second back contact electrically connected to the fifth further region. Furthermore, the semiconductor device may further comprise a conductive substrate, and the semiconductor die and the first further semiconductor die may be arranged on said conductive substrate with the back contacts facing said conductive substrate. The conductive substrate may form an electrical connection between the back contact of the semiconductor die and the back contact of the first further semiconductor die.

The first region, the second region and the third region may together form a BJT.

The second region may comprise a first sub-region and a second sub-region. The first sub-region may be relatively lowly doped with respect to the second sub-region. Furthermore, the first region and the third region may be arranged adjacent to the first sub-region and may be spaced apart from the second sub-region by said first sub-region. In addition, the fourth region may be arranged adjacent to the second sub-region and may be spaced apart from the first sub-region by said second sub-region.

Additionally or alternatively, the single further region may comprise a first further sub-region and a second further sub-region. The first further sub-region may be relatively lowly doped with respect to the second further sub-region. Furthermore, the second further region and the fourth further region may be arranged adjacent to the first further sub-region and may be spaced apart from the second further sub-region by said first further sub-region. In addition, the fifth further region may be arranged adjacent to the second further sub-region and may be spaced apart from the first further sub-region by said second further sub-region.

Due to the relative differences in dopant concentration between the first and second subregion and the first and second further subregion, the electronic component and/or electronic unit, respectively, can exhibit a relatively low capacitance, in addition to high robustness during ESD events.

The first charge type may correspond to a p-type or n-type doping, and the second charge type may correspond to an n-type or p-type doping, respectively. Additionally or alternatively, the regions corresponding to the electronic component and/or, if applicable, the further regions corresponding to the electronic unit may be ion-implanted regions.

The semiconductor die and/or, if applicable, the first further semiconductor die and/or the second further semiconductor die may be based on one of silicon, Si, silicon carbide, SiC, gallium nitride, GaN, and gallium arsenide, GaAs, technology.

According to another aspect of the present disclosure, an ESD protection device is provided that is configured to be electrically connected to an electronic circuit and to protect said electronic circuit from ESD events. The ESD protection device comprises one or more semiconductor devices as described above. Optionally, the ESD protection device may be a packaged device.

According to yet another aspect of the present disclosure, a device is provided, comprising an electronic circuit integrated on a semiconductor die, and one or more semiconductor devices as described above. The one or more semiconductor devices are integrated on the semiconductor die and are electrically connected to the electronic circuit to protect said electronic circuit from ESD events. Optionally, the device may be a packaged device.

The ensuing description above provides preferred exemplary embodiment(s) only, and is not intended to limit the scope, applicability or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Next, the present disclosure will be described in more detail with reference to the appended drawings, wherein:
Figure 1 is a schematic diagram including an ESD protection device connected to a circuit that is to be protected;
Figure 2 is a schematic diagram of an ESD protection device known in the art;
Figure 3A is a schematic diagram of a semiconductor device according to some embodiments;
Figures 3B and 3C are simplified cross-sectional views of the semiconductor device shown in Figure 3A;
Figure 4A is a schematic diagram of a semiconductor device according some embodiments;
Figures 4B and 4C are simplified cross-sectional views of the semiconductor device shown in Figure 4A;
Figure 5A is a schematic diagram of a semiconductor device according to some embodiments; and
Figures 5B-5D are simplified cross-sectional views of the semiconductor device shown in Figure 5A.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the detailed description using the singular or plural number may also include the plural or singular number respectively. The word "or," in reference to a list of two or more items, covers all of the following interpretations of the word: any of the items in the list, all of the items in the list, and any combination of the items in the list.

The teachings of the technology provided herein can be applied to other systems, not necessarily the system described below. The elements and acts of the various examples described below can be combined to provide further implementations of the technology. Some alternative implementations of the technology may include not only additional elements to those implementations noted below, but also may include fewer elements.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

To reduce the number of claims, certain aspects of the technology are presented below in certain claim forms, but the applicant contemplates the various aspects of the technology in any number of claim forms.

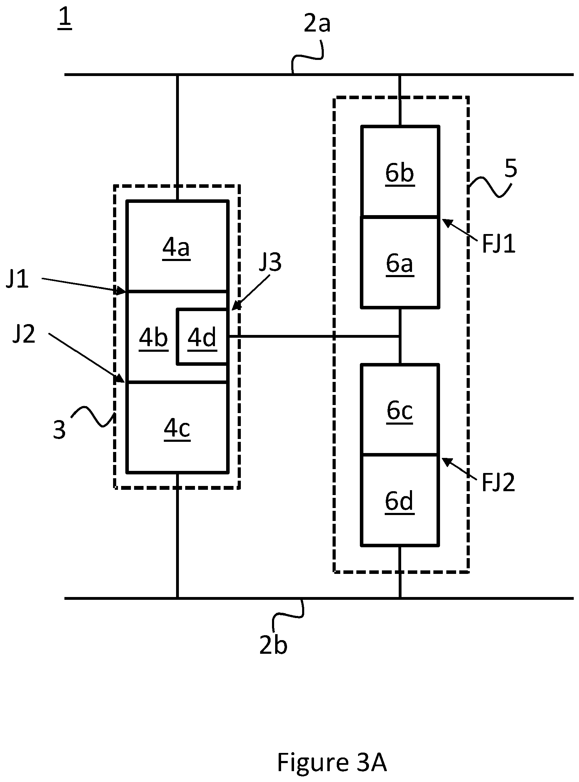

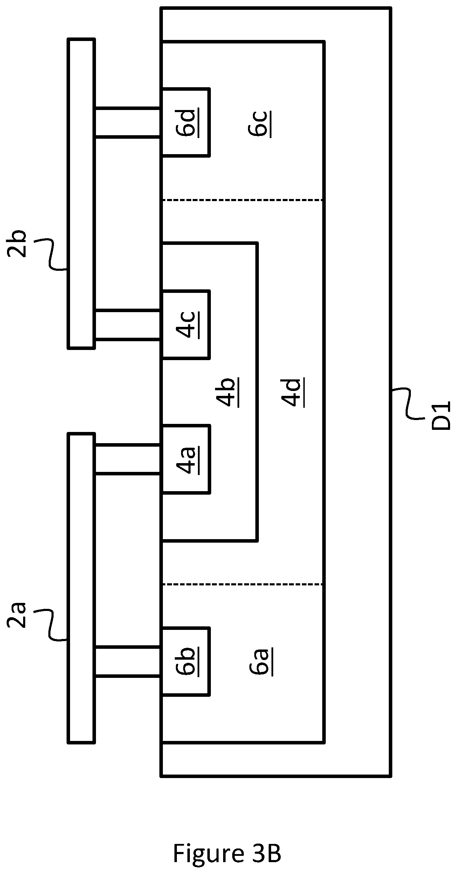

In Figure 3A, a semiconductor device 1 is shown according to an embodiment of the present disclosure. Furthermore, in Figure 3B, an exemplary cross-sectional view of semiconductor device 1 of Figure 3A is shown.

Semiconductor device 1 comprises an electronic component 3 that is integrated on a semiconductor die D1. Electronic component 3 is formed by regions in semiconductor die D1, including a first region 4a, a second region 4b, a third region 4c and a fourth region 4d. First region 4a, third region 4c and fourth region 4d are doped with a same dopant type corresponding to a first charge type, while second region 4b is doped with an opposite dopant type corresponding to a second charge type. For example, first region 4a, third region 4c and fourth region 4d are p-type doped regions, while second region 4b is an n-type doped region. Due to the difference in charge types between adjacent regions, electronic component 3 comprises a first PN junction J1 between first region 4a and second region 4b, a second PN junction J2 between second region 4b and third region 4c, and a third PN junction J3 between second region 4b and fourth region 4d. In the embodiment shown in Figure 3B, first region 4a, second region 4b and third region 4c together form a lateral BJT.

First region 4a is electrically connected to a first device terminal 2a, and third region 4c is electrically connected to a second device terminal 2b. First device terminal 2a and second device terminal 2b may correspond to terminals of semiconductor device 1, terminals of ESD protection device 20 shown in Figure 1, or terminals of an external circuit to be protected.

Semiconductor device 1 further comprises an electronic unit 5 that is electrically connected between first device terminal 2a, second device terminal 2b and fourth region 4d. In the embodiments shown in Figures 3A and 3B, electronic unit 5 comprises a first diode formed by a first further region 6a of the first charge type and a second further region 6b of the second charge type. First further region 6a and fourth region 4d are adjacently arranged, and second further region 6b is electrically connected to first device terminal 2a. Similarly, electronic unit 5 comprises a second diode formed by a third further region 6c of the first charge type and a fourth further region 6d of the second charge type. Third further region 6c and fourth region 4d are adjacently arranged, and fourth further region 6d is electrically connected to first device terminal 2a. Due to the difference in charge types between adjacent regions, a first further PN junction FJ1 is formed between first further region 6a and second further region 6b, and a second further PN junction FJ2 is formed between third further region 6c and fourth further region 6d.

Here, it is noted that fourth region 4d may be considered electrically connected to each of first further region 6a and third further region 6c due to said further regions 6a, 6c being arranged adjacent to fourth region 4d. That is, within the context of the present disclosure, for regions in the semiconductor die(s), the term 'electrically connected' may correspond to an electrical connection via a conductive material or component, and/or to being adjacently arranged or in physical contact.

Since electronic component 3 and electronic unit 5 are both integrated on semiconductor die D1 in the embodiment shown in Figure 3B, first device terminal 2a and second device terminal 2b may correspond to terminals of semiconductor device 1 and may be formed in one or more metal layers of a metal layer stack (not shown) arranged on top of said semiconductor die D1. In other words, first region 4a and second further region 6a, as well as third region 4c and fourth further region 6d, may be electrically connected through said metal layer stack, for example through vias, instead of being connected via an individual terminals of semiconductor device 1 to an external terminal, for example a terminal of a circuit to be protected.

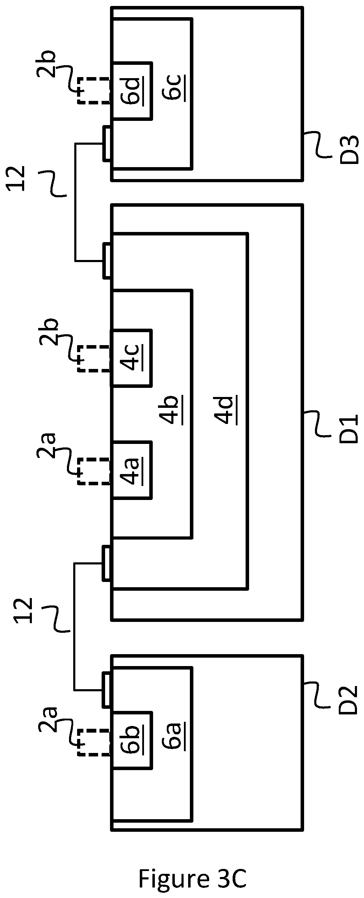

However, it is noted that the present disclosure is not limited to the configuration shown in Figure 3B. For example, electronic unit 5 may be partially or fully integrated on one or more further semiconductor die, instead of on semiconductor die D1 on which electronic component 3 is integrated. As shown in Figure 3C, the first diode of electronic unit 5 may for example be integrated on a first further semiconductor die D2 and the second diode on a second further semiconductor die D3. In other embodiments, the first and second diode of electronic unit 5 are integrated on a same further semiconductor die (not shown), or one of the first and second diode is integrated on semiconductor die D1 while the other is integrated on a further semiconductor die.

In some embodiments, semiconductor die D1 as well as the one or more further semiconductor dies (e.g., first and second further semiconductor die D2, D3) are comprised in a same device package (not shown) having leads via which electronic component 3 and electronic unit 5 can be connected to an external circuit to be protected. In that case, the electrical connections between fourth region 4d and first and third further region 6a, 6c could be formed internally to the package, though they may also be formed externally to the package, for example by externally connecting the leads.

For example, as shown in Figure 3C, electrical connections 12 can be used to electrically connect fourth region 4d to first further region 6a and third further region 6c. Electrical connections 12 may for example correspond to bondwires, metal interconnections, or the like.

In other embodiments, semiconductor die D1, first further semiconductor die D2 and/or second further semiconductor die D3 are comprised in individual device packages. The electrical connections between fourth region 4d and first and third further region 6a, 6c can then be formed externally to said device packages.

Hereinafter, for convenience, embodiments of the present disclosure will be described with the first charge type corresponding to a p-type doping, and the second charge type corresponding to an n-type doping. However, it is noted that the present disclosure similarly envisages a semiconductor device in which the first charge type corresponds to an n-type doping and in which the second charge type corresponds to a p-type doping.

Prior to an ESD event, none of the PN junctions between adjacent regions of semiconductor device 1 are forward-biased. Furthermore, second region 4b, fourth region 4d, first further region 6a and third further region 6c are each at a floating potential. As a result, the electrical potential at said regions will be self-adjusting with respect to first device terminal 2a and second device terminal 2b.

During an ESD event having a positive polarity at first device terminal 2a with respect to second device terminal 2b, a voltage across electronic component 3 increases. During this voltage increase, the floating electrical potential at second region 4b will self-adjust until avalanche breakdown occurs at second PN junction J2 or third PN junction J3. The avalanche breakdown enables a current to flow through said junction, which also allows first PN junction J1 to become forward-biased for an ESD current to flow from first device terminal 2a to second device terminal 2b.

For example, if breakdown occurs at second PN junction J2 and first PN junction J1 becomes forward-biased due to the self-adjusting electrical potential of second region 4b, then a current can flow from first device terminal 2a to second device terminal 2b through said junctions. In that case, the current flow through second region 4b effectively acts as a base current for the BJT formed by first region 4a, second region 4b and fourth region 4d. This base current enables an additional 'collector' current to flow through said BJT, that is, through first region 4a, second region 4b and fourth region 4d. In this embodiment, second further PN junction FJ2 of the second diode can become forward-biased due to the self-adjusting electrical potential at third further region 6c. As such, the ESD event can be further discharged via fourth region 4d and via the second diode. By including fourth region 4d in conjunction with electronic unit 5, a size of the 'base-collector' junction of electronic component is effectively increased as it is now formed of both second PN junction J2 and third PN junction J3.

In another example, if avalanche breakdown occurs at third PN junction J3 instead, then a current can flow from first device terminal 2a to second device terminal 2b via said junction and via first PN junction J1 and second further PN junction FJ2, once forward-biased, similarly to the above. In that case, similarly, the current flow through second region 4b effectively acts as a base current for the BJT formed by first region 4a, second region 4b and third region 4c, thereby enabling an additional 'collector' current to flow through said regions. Since the occurrence of avalanche breakdown depends on the breakdown voltage of the respective junction, either of second PN junction J2 and third PN junction J3 can be designed to break down first, for example by selecting relative dopant concentrations and dimensions.

On the other hand, if the ESD event occurs with a positive polarity at second device terminal 2b with respect to first device terminal 2a, the floating electrical potential of second region 4b will self-adjust until avalanche breakdown occurs at first PN junction J1 or third PN junction J3. Similarly to the above, avalanche breakdown at first PN junction J1 enables a current flow through said junction and enables second PN junction J2 to become forward-biased to allow a current to flow from second device terminal 2a to first device terminal 2b. The current flow through second region 4b then enables an additional current flow through third PN junction J3, once first further PN junction FJ1 becomes forward-biased. Alternatively, breakdown at third PN junction J3 enables a current flow through said junction, and through second PN junction J2 and first further PN junction FJ1, once forward-biased. In that case, again, the current flow through second region 4b acts as a base current that enables an additional 'collector' current flow through first PN junction J1. As a result, fourth region 4d acts as an 'additional' collector region irrespective of the polarity of the voltage across semiconductor device 1, due to the current draining to fourth region 4d by electronic unit 5.

For completeness, it is noted that a direction of the current flow through electronic unit 5 may depend on the dopant type selected for the first and second charge type. For example, in the above, the first charge type is assumed to be p-type. On the other hand, if the first charge type is n-type and the second charge type is p-type instead, then the first and second diode of electronic unit 5 are effectively 'reversed'. As a result, a current through fourth region 4d will pass through part of electronic unit 5 (the first diode or the second diode) first. However, the operation principle remains substantially the same regardless of the selected dopant type in the embodiments of the present disclosure.

In each of the above described cases, semiconductor device 1 'activates' based on the voltage across the terminals to which it is connected. For example, semiconductor device 1 activates during an ESD event that causes an excessively high voltage across first device terminal 2a and second device terminal 2b. Once semiconductor device 1 is active, the charge from the ESD event can be safely drained through semiconductor device 1 due to its relatively high current handling capability. As such, semiconductor device 1 can be particularly useful in protecting a circuit from damages due to excessively high currents and/or voltages.

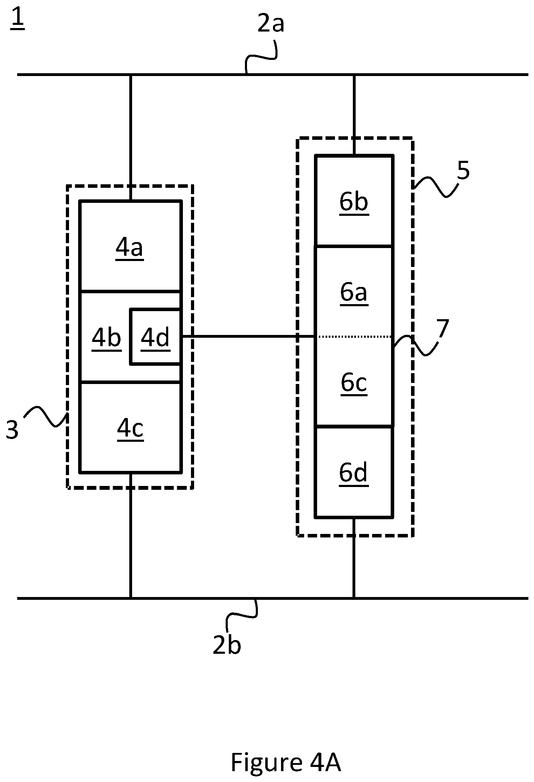

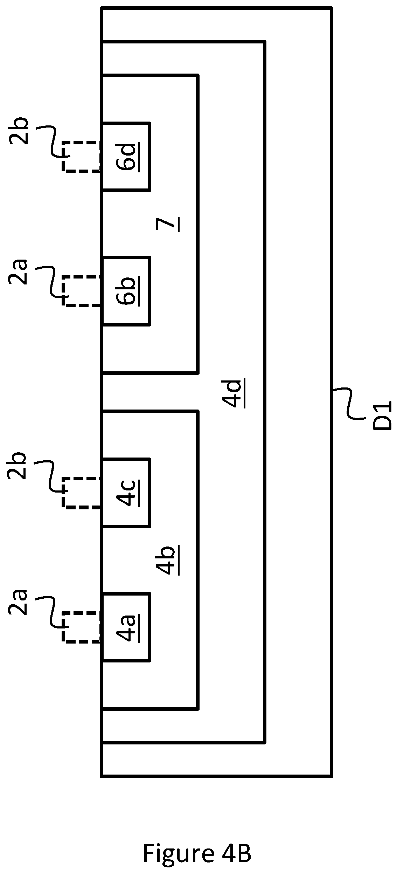

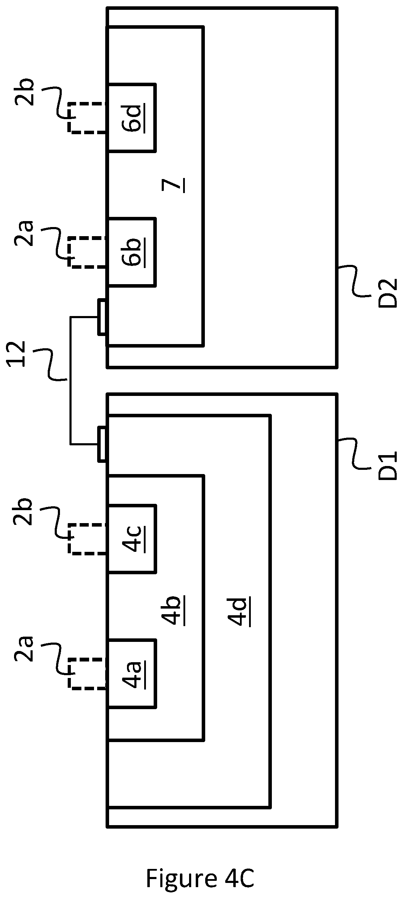

In Figure 4A, a semiconductor device 1 according to another embodiment is shown. Figure 4B shows a simplified cross-sectional view of semiconductor device 1 of Figure 4A wherein electronic component 3 and electronic unit 5 are both integrated on semiconductor die D1. Figure 4C shows a cross-sectional view of semiconductor device 1 of Figure 4A wherein electronic component 3 is integrated on semiconductor die D1 and in which electronic unit 5 is integrated on first further semiconductor die D2. For convenience, only a portion of connections leading to first device terminal 2a and second device terminal 2b are indicated.

Semiconductor device 1 shown in Figure 4A differs from that shown in Figure 3A in that first further region 6a and third further region 6c are adjacently arranged and collectively form a single further region 7. More particularly, in Figure 4A, first through fourth further regions 6a-6d together form a BJT, the base of which corresponds to single further region 7.

In the embodiments shown in Figures 4A-4C, like the embodiments described above, a first current path is formed via first region 4a, second region 4b and third region 4c, and a second current path is formed via second region 4b, fourth region 4d, either of the first and third region 4a, 4c, and electronic unit 5. However, in Figures 4A-4C, a current along the second current path will flow through further region 7 and will effectively form a base current for the BJT formed by first through fourth further regions 6a-6d. As a result, a third current path is formed via which an additional 'collector' current can flow, the third current path being directly via electronic unit 5 from first device terminal 2a to second device terminal 2b, or vice versa depending on the polarity of the voltage.

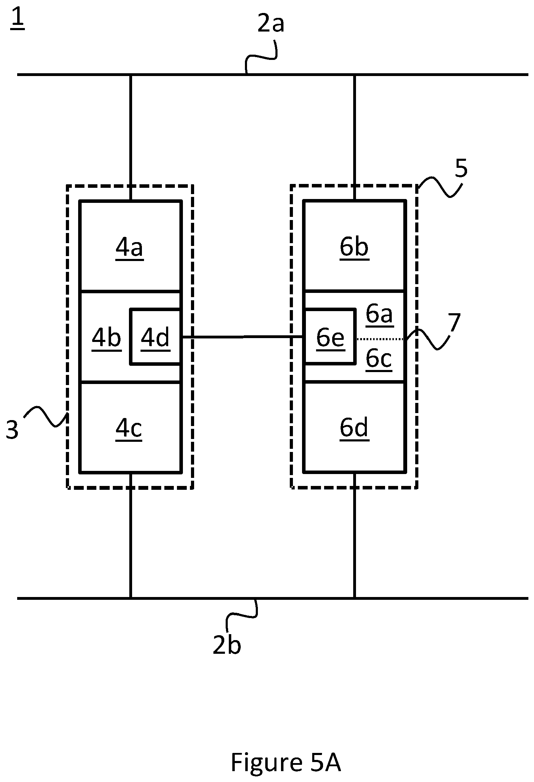

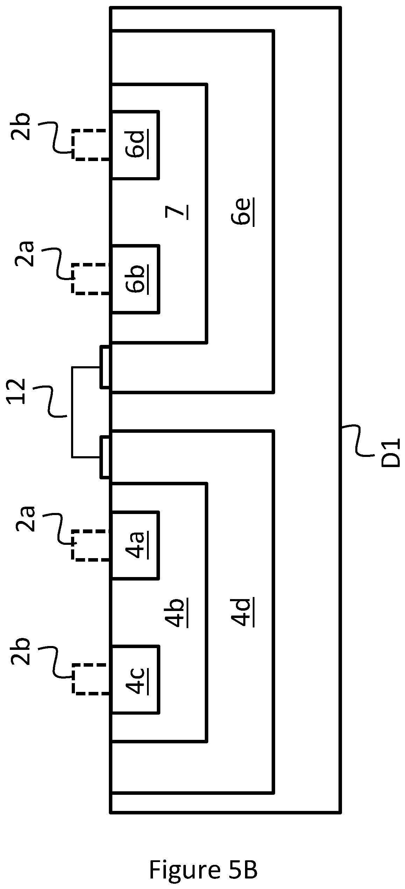

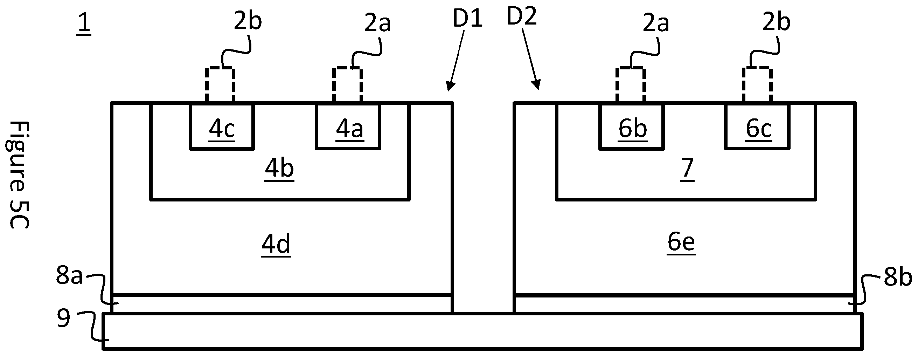

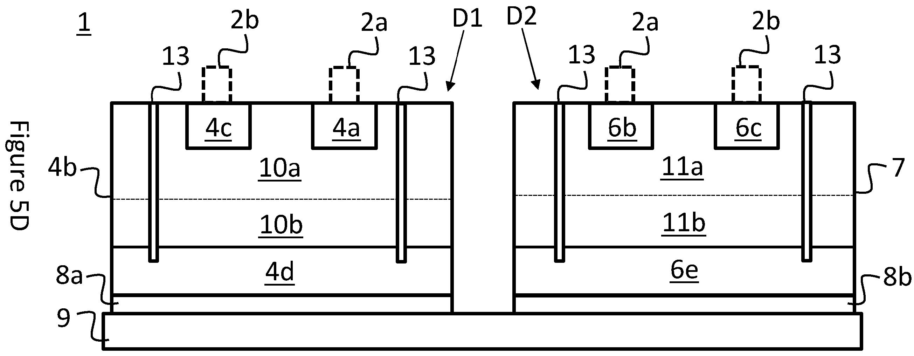

In Figure 5A, a semiconductor device 1 according to another embodiment is shown. Figure 5B shows a simplified cross-sectional view of semiconductor device 1 of Figure 5A wherein electronic component 3 and electronic unit 5 are both integrated on semiconductor die D1. Figures 5C and 5D show a simplified cross-sectional view of semiconductor device 1 of Figure 5A wherein electronic component 3 is integrated on semiconductor die D1 and wherein electronic unit 5 is integrated on first further semiconductor die D2.

The embodiment shown in Figures 5A differs from that shown in Figures 4A in that electronic unit 5 further comprises a fifth further region 6e arranged adjacent to further region 7 and forming a third further PN junction FJ3 therewith. Fifth further region 6e is electrically connected to or arranged adjacent to fourth region 4d. A structure of electronic component 3 and electronic unit 5 may thus be substantially identical, albeit having opposite charge types for corresponding regions thereof. In other words, each of electronic component 3 and electronic unit 5 comprise an open base BJT comprising an additional region, formed by fourth region 4d and fifth further region 6e, respectively, that functions as a collector irrespective of the polarity of the voltage across semiconductor device 1.

In Figure 5B, semiconductor die D1 has both electronic component 3 and electronic unit 5 integrated thereon. The electrical connection between fourth region 4d and fifth further region 6e is formed by an electrical connection 12, which may for example correspond to one or more bondwires, a metal interconnection, or the like. Alternatively, although not shown in the figures, fourth region 4d and fifth further region 6e may be directly adjacently arranged on semiconductor die D1, in which case electrical connection 12 may be omitted. Furthermore, although not shown in the figures, fifth further region 6e may be directly adjacently arranged to both fourth region 4d and second region 4b.

In Figure 5C, semiconductor die D1 comprises a back contact 8a electrically connected to fourth region 4d, and further semiconductor die D2 comprises a back contact 8b electrically connected to fifth further region 6e. In this manner, fourth region 4d and fifth further region 6e can be electrically connected to one another via a conductive substrate 9 on which semiconductor die D1 and further semiconductor die D2 are arranged with back contacts 8a, 8b facing conductive substrate 9.

Here, it is noted that the inclusion of back contacts 8a, 8b is also envisaged in other embodiments of the present disclosure in which electronic component 3 and electronic unit 5 are respectively integrated on different semiconductor dies. For example, in so far as electronic component 3 and electronic unit 5 are realized on different semiconductor dies, said dies may optionally be provided with back contacts to realize an electrical connection between fourth region 4d and fifth further region 6e in Figure 4A or between fourth region 4d and one or both of first further subregion 6a and third further subregion 6c in Figure 3A.

Figure 5D differs from Figure 5C in that second region 4b is divided in a first subregion 10a and a second subregion 10b, and single further region 7 is divided in a first further subregion 11a and a second further subregion 11b. Fourth region 4d is electrically connected to a back contact 8a of semiconductor die D1, and fifth further 6e is electrically connected to a back contact 8b of further semiconductor die D2. Furthermore, semiconductor die D1 and/or further semiconductor die D2 may comprise isolation structures 13, such as trenches or an oxide material arranged in said semiconductor die.

In this embodiment, first subregion 10a and first further subregion 11a may have a lower dopant concentration than second subregion 10b and second further subregion 11b, respectively, thereby reducing the capacitive load of semiconductor device 1 on a circuit to which it is connected, in absence of an ESD event. However, the present invention is not limited thereto, and one or both of second region 4b and single further region 7 may instead be a substantially uniformly doped region. In other words, the division into subregions as shown in Figure 5C is optional, and may be omitted for second region 4b, single further region 7, or both.

In the embodiment of Figure 5A, fourth region 4d and fifth further region 6e may be electrically connected via an interconnection element, such as conductive substrate 9 and back contacts 8a, 8b as shown in Figure 5C. Alternatively, or additionally, if electronic component 3 and electronic unit 5 are both integrated on semiconductor die D1, then fourth region 4d and fifth further region 6e may be arranged adjacent to one another and may as such be electrically connected. In that case, an intermediate PN junction is formed between fourth region 4d and fifth further region 6e.

In the embodiments described above, it is noted that any of first through fourth regions 4a-4d and any of first through fifth further regions 6e may be ion-implanted regions. Furthermore, they may be arranged in a doped substrate of the corresponding semiconductor die(s), or in an epitaxial layer that is grown on top of said semiconductor substrate.

For example, in the embodiment shown in Figure 5C, first and third region 4a, 4c may be arranged and surrounded by an epitaxial area forming second region 4b. Furthermore, the epitaxial area may be formed on a semiconductor substrate that forms fourth region 4d. This can similarly be applied to electronic unit on first further semiconductor die D2 in Figure 5C.

For all embodiments described above, the breakdown voltages of the different junctions can be designed differently, to adapt to different intended electrical characteristics. Next, exemplary cases are described for the embodiments shown in Figure 5A-5C. In these examples, first PN junction J1 has a first breakdown voltage, second PN junction J2 has a second breakdown voltage, and third PN junction J3 has a third breakdown voltage. Similarly, first further PN junction FJ1 has a first further breakdown voltage, second further PN junction FJ2 has a second further breakdown voltage, and third further PN junction FJ3 has a third further breakdown voltage.

In a first example, the first and second breakdown voltage are each chosen to be less than a sum of the third breakdown voltage and the third further breakdown voltage, and the first and second further breakdown voltage are each chosen to be less than a sum of the third breakdown voltage and the third further breakdown voltage. In that case, a first BJT formed by first through third regions 4a-4c and a first further BJT formed by first through fourth further regions 6a-6d are in avalanche breakdown mode. The current flow through the first BJT due to the avalanche breakdown in electronic component 3 acts as a base current for a second BJT formed by second region 4b, fourth region 4c and either of first and third region 4a, 4c, depending on the polarity of the voltage across semiconductor device 1. Similarly, the current flow through the first further BJT due to the avalanche breakdown in electronic unit 5 acts as a base current for a second further BJT formed by first and third further region 6a, 6c, fifth further region 6e and either of second and fourth further region 6b, 6d, depending on the polarity of the voltage across semiconductor device 1.

In a second example, the first and second breakdown voltage are each chosen to be greater than a sum of the third breakdown voltage and the third further breakdown voltage, and the first and second further breakdown voltage are each chosen to be greater than a sum of the third breakdown voltage and the third further breakdown voltage. In that case, the second BJT and second further BJT are in breakdown mode, and the resulting currents each act as a base current for the first BJT and first further BJT, respectively.

In a preferred embodiment, the first breakdown voltage, second breakdown voltage, first further breakdown voltage and second further breakdown voltage are each identical or similar. More preferably, an even more robust semiconductor device is obtained when the mentioned breakdown voltages are roughly equal to a sum of the third breakdown voltage and third further breakdown voltage, at least partly due to the increased current handling capability of the semiconductor device.

It will be appreciated that, although only one region is shown for each of first through fourth region 4a-4c and first through fifth further region 6a-6e, the present disclosure is not limited thereto. For example, electronic component 3 may comprise a plurality of said first regions 4a and a plurality of said third regions 4c arranged in an interleaved, finger-like pattern. Similarly, electronic unit 5 may comprise a plurality of said second further regions 6b and a plurality of said fourth further regions 6d arrange din an interleaved, finger-like pattern. In other words, one or both of electronic component 3 and electronic unit 5 may be realized in a multi-finger structure, as will be appreciated by a person skilled in the art.

In the above embodiments, various dopant concentrations may be selected for different regions in semiconductor device 1. As an example only, first region 4a, third region 4c, second further region 6b and/or fourth further region 6d may have a dopant concentration in a range between 1e17 - 1e20 per cm³. Furthermore, as an example only, fourth region 4d and/or fifth further subregion 6e may have a dopant concentration in a range between 1e16 - 1e19 per cm³. In addition, as an example only, second region 4b, first further subregion 6a, third further subregion 6c and/or, if applicable, single further region 7, or second subregion 10b and second further subregion 11b, may have a dopant concentration in a range between 1e15 - 1e17 per cm³. Furthermore, as an example only, first subregion 10a and first further subregion 11a may have a dopant concentration in a range between 1e14 - 1e16 per cm³.

One or more regions that are in contact with a terminal, such as with a metal, may comprise a portion that is highly doped (e.g., a dopant concentration between 1e17 - 1e20 per cm³) to realize a low-Ohmic contact, and the terminal may be electrically connected to and physically contact said portion, as will be appreciated by a person skilled in the art.

In the description above, for the purposes of explanation, numerous specific details are set forth in order to provide a thorough understanding of implementations of the disclosed technology.

It will be apparent, however, to one skilled in the art that embodiments of the disclosed technology may be practiced without some of these specific details, and that the scope of the present invention is defined by the appended claims.

## Claims

1. A semiconductor device (1) comprising a semiconductor die (D1) having an electronic component (3) integrated thereon, wherein the electronic component (3) comprises regions in the semiconductor die (D1), the regions comprising:
a first region (4a) of a first charge type configured to be electrically connected to a first device terminal (2a);
a second region (4b) of a second charge type arranged adjacent to and forming a first PN junction with the first region (4a);
a third region (4c) of the first charge type arranged adjacent to and forming a second PN junction with the second region (4b), the third region (4c) being spaced apart from the first region (4a) by said second region (4b) and being configured to be electrically connected to a second device terminal (2b); and
a fourth region (4d) of the first charge type arranged adjacent to and forming a third PN junction with the second region (4b), the fourth region (4d) being spaced apart from the first region (4a) and third region (4c) by said second region (4b),
wherein the semiconductor device (1) further comprises an electronic unit (5) configured to be electrically connected between the first device terminal (2a), the second device terminal (2b) and the fourth region (4d), wherein, during operation, the electronic unit (5) is configured to provide a first current path or a second current path in dependence of a polarity of a voltage across the first device terminal (2a) and the second device terminal (2b),
**characterised in that** either the first charge type corresponds to an n-type doping, and the first current path and the second current path extend from the first device terminal (2a) and the second device terminal (2b), respectively, towards the fourth region (4d), or or the first charge type corresponds to a p-type doping, and the first current path and the second current path extend from the fourth region (4d) to the first device terminal (2a) and the second device terminal (2b), respectively.

2. The semiconductor device (1) according to claim 1, wherein the electronic unit (5) comprises further regions comprised in the semiconductor die (D1) or one or more further semiconductor dies on which said electronic unit (5) is integrated, the further regions comprising:
a first further region (6a) of the first charge type;
a second further region (6b) of the second charge type arranged adjacent to and forming a first further PN junction with the first further region (6a), the second further region being configured to be electrically connected to the first device terminal (2a);
a third further region (6c) of the first charge type; and
a fourth further region (6d) of the second charge type arranged adjacent to and forming a second further PN junction with the third further region (6c), the fourth further region being configured to be electrically connected to the second device terminal (2b),
wherein the first further region (6a) and the second further region (6b) are comprised in the semiconductor die (D1) or in a first further semiconductor die, and wherein the third further region (6c) and the fourth further region (6d) are comprised in the semiconductor die (D1), the first further semiconductor die or a second further semiconductor die,
wherein the first current path extends through the first further region (6a) and the second further region (6b), and wherein the second current path extends through the third further region (6c) and the fourth further region (6d).

3. The semiconductor device (1) according to claim 2, wherein the first further region (6a) and the third further region (6c) are each electrically connected to the fourth region (4d),
wherein the first further region (6d) and the second further region (6b) together form a first diode, and wherein the third further region (6c) and the fourth further region (6d) together form a second diode.

4. The semiconductor device (1) according to claim 2, in so far as the first through fourth further regions (6a-6d) are all comprised in the semiconductor die (D1) or on the first further semiconductor die, wherein the first further region (6a) and the third further region (6c) are adjacently arranged and form a single further region (7).

5. The semiconductor device according to claim 4, wherein the single further region (7) is electrically connected to the fourth region (4d), and
wherein the first further region (6a), the second further region (6b), the third further region (6c) and the fourth further region (6d) together form a bipolar junction transistor, BJT.

6. The semiconductor device (1) according to claim 4, wherein the further regions further comprise a fifth further region (6e) of the second charge type arranged adjacent to and forming a third further PN junction with the single further region (7), the fifth further region (6e) being electrically connected to the fourth region (4d) and being comprised in the semiconductor die or the first further semiconductor die,
wherein the first current path and the second current path each additionally extend through the fifth further region (6e).

7. The semiconductor device (1) according to claim 6, in so far as the first through fifth regions (6a-6e) are all comprised in the semiconductor die, wherein the fourth region (4d) is arranged adjacent to and forms an intermediate PN junction with the fifth further region (6e).

8. The semiconductor device (1) according to claim 7, wherein the fifth further region (6e) and the second region (4b) are adjacently arranged to together form a contiguous region, or wherein the fourth region (4d) is and the single further region (7) are adjacently arranged to together form a contiguous region.

9. The semiconductor device (1) according to claim 6, in so far as the first through fifth further regions (6a-6e) are all comprised in the first further semiconductor die, wherein the semiconductor comprises a first back contact (8a) electrically connected to the fourth region (4d), and wherein the first further semiconductor die comprises a second back contact (8b) electrically connected to the fifth further region (6e),
wherein the semiconductor device (1) further comprises a conductive substrate (9), the semiconductor die and the first further semiconductor die being arranged with their respective back contacts (8a, 8b) facing the conductive substrate, wherein the conductive substrate forms an electrical connection between the back contact (8a) of the semiconductor die and the back contact (8b) of the first further semiconductor die.

10. The semiconductor device (1) according to any of the previous claims, wherein the first region (4a), the second region (4b) and the third region (4c) together form a BJT.

11. The semiconductor device (1) according to any of the previous claims, wherein the second region (4b) comprises a first sub-region (10a) and a second sub-region (10b), the first sub-region (10a) being relatively lowly doped with respect to the second sub-region (10b), wherein the first region (4a) and the third region (4c) are arranged adjacent to the first sub-region (10a) and are spaced apart from the second sub-region (10b) by said first sub-region (10a), and wherein the fourth region (4d) is arranged adjacent to the second sub-region (10b) and is spaced apart from the first sub-region (10a) by said second sub-region (10b); and/or
wherein the single further region (7) comprises a first further sub-region (11a) and a second further sub-region (11b), the first further sub-region (11a) being relatively lowly doped with respect to the second further sub-region (11b), wherein the second further region (6b) and the fourth further region (6d) are arranged adjacent to the first further sub-region (11a) and are spaced apart from the second further sub-region (11b) by said first further sub-region (11a), and wherein the fifth further region (6e) is arranged adjacent to the second further sub-region (11b) and is spaced apart from the first further sub-region (11a) by said second further sub-region (11b).

12. The semiconductor device (1) according to any of the previous claims,
wherein the regions corresponding to the electronic component (3) and/or, if applicable, the further regions corresponding to the electronic unit (5) are ion-implanted regions.

13. The semiconductor device (1) according to any of the previous claims, wherein the semiconductor die and/or, if applicable, the first further semiconductor die and/or the second further semiconductor die are based on one of silicon, Si, silicon carbide, SiC, gallium nitride, GaN, and gallium arsenide, GaAs, technology.

14. An electrostatic discharge, ESD, protection device (20) configured to be electrically connected to an electronic circuit (30) and to protect said electronic circuit (30) from ESD events,
wherein the ESD protection device (20) comprises one or more semiconductor devices (1) as defined in any of the previous claims, and
wherein the ESD protection device (20) is preferably a packaged device.

15. A device comprising an electronic circuit integrated on a semiconductor die, and one or more semiconductor devices (1) as defined in any of the claims 1-13, wherein the one or more semiconductor devices (1) are integrated on the semiconductor die and are electrically connected to the electronic circuit to protect said electronic circuit from ESD events,
wherein the device is preferably a packaged device.

## Patentansprüche

1. Halbleitervorrichtung (1), die einen Halbleiterchip (D1) mit einer darauf integrierten elektronischen Komponente (3) umfasst, wobei die elektronische Komponente (3) Regionen in dem Halbleiterchip (D1) umfasst, wobei die Regionen Folgendes umfassen:
eine erste Region (4a) eines ersten Ladungstyps, die dazu konfiguriert ist, mit einem ersten Vorrichtungsanschluss (2a) elektrisch verbunden zu werden;
eine zweite Region (4b) eines zweiten Ladungstyps, die neben der ersten Region (4a) angeordnet ist und einen ersten PN-Übergang zu dieser bildet;
eine dritte Region (4c) des ersten Ladungstyps, die neben der zweiten Region (4b) angeordnet ist und einen zweiten PN-Übergang zu dieser bildet, wobei die dritte Region (4c) durch die zweite Region (4b) von der ersten Region (4a) beabstandet und dazu konfiguriert ist, mit einem zweiten Vorrichtungsanschluss (2b) elektrisch verbunden zu werden; und
eine vierte Region (4d) des ersten Ladungstyps, die neben der zweiten Region (4b) angeordnet ist und einen dritten PN-Übergang zu dieser bildet, wobei die vierte Region (4d) durch die zweite Region (4b) von der ersten Region (4a) und der dritten Region (4c) beabstandet ist,
wobei die Halbleitervorrichtung (1) ferner eine elektronische Einheit (5) umfasst, die dazu konfiguriert ist, mit dem ersten Vorrichtungsanschluss (2a), dem zweiten Vorrichtungsanschluss (2b) und der vierten Region (4d) elektrisch verbunden zu werden, wobei die elektronische Einheit (5) während des Betriebs dazu konfiguriert ist, einen ersten Stromweg oder einen zweiten Stromweg in Abhängigkeit von einer Polarität einer Spannung über den ersten Vorrichtungsanschluss (2a) und den zweiten Vorrichtungsanschluss (2b) bereitzustellen,
**dadurch gekennzeichnet, dass** entweder der erste Ladungstyp einer n-Dotierung entspricht und der erste Stromweg und der zweite Stromweg von dem ersten Vorrichtungsanschluss (2a) bzw. dem zweiten Vorrichtungsanschluss (2b) zu der vierten Region (4d) hin verlaufen oder der erste Ladungstyp einer p-Dotierung entspricht und der erste Stromweg und der zweite Stromweg von der vierten Region (4d) zu dem ersten Vorrichtungsanschluss (2a) bzw. dem zweiten Vorrichtungsanschluss (2b) hin verlaufen.

2. Halbleitervorrichtung (1) nach Anspruch 1, wobei die elektronische Einheit (5) weitere Regionen umfasst, die in dem Halbleiterchip (D1) oder einem oder mehreren weiteren Halbleiterchips, auf dem/denen die elektronische Einheit (5) integriert ist, umfasst sind, wobei die weiteren Regionen Folgendes umfassen:
eine erste weitere Region (6a) des ersten Ladungstyps;
eine zweite weitere Region (6b) des zweiten Ladungstyps, die neben der ersten weiteren Region (6a) angeordnet ist und einen ersten weiteren PN-Übergang zu dieser bildet, wobei die zweite weitere Region dazu konfiguriert ist, mit dem ersten Vorrichtungsanschluss (2a) elektrisch verbunden zu werden;
eine dritte weitere Region (6c) des ersten Ladungstyps; und
eine vierte weitere Region (6d) des zweiten Ladungstyps, die neben der dritten weiteren Region (6c) angeordnet ist und einen zweiten weiteren PN-Übergang zu dieser bildet, wobei die vierte weitere Region dazu konfiguriert ist, mit dem zweiten Vorrichtungsanschluss (2b) elektrisch verbunden zu werden,
wobei die erste weitere Region (6a) und die zweite weitere Region (6b) in dem Halbleiterchip (D1) oder in einem ersten weiteren Halbleiterchip umfasst sind und wobei die dritte weitere Region (6c) und die vierte weitere Region (6d) in dem Halbleiterchip (D1), dem ersten weiteren Halbleiterchip oder einem zweiten weiteren Halbleiterchip umfasst sind,
wobei der erste Stromweg durch die erste weitere Region (6a) und die zweite weitere Region (6b) verläuft und wobei der zweite Stromweg durch die dritte weitere Region (6c) und die vierte weitere Region (6d) verläuft.

3. Halbleitervorrichtung (1) nach Anspruch 2, wobei die erste weitere Region (6a) und die dritte weitere Region (6c) je mit der vierten Region (4d) elektrisch verbunden sind,
wobei die erste weitere Region (6d) und die zweite weitere Region (6b) zusammen eine erste Diode bilden und wobei die dritte weitere Region (6c) und die vierte weitere Region (6d) zusammen eine zweite Diode bilden.

4. Halbleitervorrichtung (1) nach Anspruch 2, soweit die erste bis vierte weitere Region (6a-6d) alle in dem Halbleiterchip (D1) oder auf dem ersten weiteren Halbleiterchip umfasst sind, wobei die erste weitere Region (6a) und die dritte weitere Region (6c) nebeneinander angeordnet sind und eine einzelne weitere Region (7) bilden.

5. Halbleitervorrichtung nach Anspruch 4, wobei die einzelne weitere Region (7) mit der vierten Region (4d) elektrisch verbunden ist und
wobei die erste weitere Region (6a), die zweite weitere Region (6b), die dritte weitere Region (6c) und die vierte weitere Region (6d) zusammen einen Bipolartransistor, BJT, bilden.

6. Halbleitervorrichtung (1) nach Anspruch 4, wobei die weiteren Regionen ferner eine fünfte weitere Region (6e) des zweiten Ladungstyps, die neben der einzelnen weiteren Region (7) angeordnet ist und einen dritten weiteren PN-Übergang zu dieser bildet, umfassen, wobei die fünfte weitere Region (6e) mit der vierten Region (4d) elektrisch verbunden ist und in dem Halbleiterchip oder dem ersten weiteren Halbleiterchip umfasst ist,
wobei der erste Stromweg und der zweite Stromweg je zusätzlich durch die fünfte weitere Region (6e) verlaufen.

7. Halbleitervorrichtung (1) nach Anspruch 6, soweit die erste bis fünfte Region (6a-6e) alle in dem Halbleiterchip umfasst sind, wobei die vierte Region (4d) neben der fünften weiteren Region (6e) angeordnet ist und einen dazwischenliegenden PN-Übergang zu dieser bildet.

8. Halbleitervorrichtung (1) nach Anspruch 7, wobei die fünfte weitere Region (6e) und die zweite Region (4b) nebeneinander angeordnet sind, um zusammen eine zusammenhängende Region zu bilden, oder wobei die vierte Region (4d) und die einzelne weitere Region (7) nebeneinander angeordnet sind, um zusammen eine zusammenhängende Region zu bilden.

9. Halbleitervorrichtung (1) nach Anspruch 6, soweit die erste bis fünfte weitere Region (6a-6e) alle in dem ersten weiteren Halbleiterchip umfasst sind, wobei der Halbleiter einen ersten Rückseitenkontakt (8a), der mit der vierten Region (4d) elektrisch verbunden ist, umfasst und wobei der erste weitere Halbleiterchip einen zweiten Rückseitenkontakt (8b), der mit der fünften weiteren Region (6e) elektrisch verbunden ist, umfasst,
wobei die Halbleitervorrichtung (1) ferner ein leitfähiges Substrat (9) umfasst, wobei der Halbleiterchip und der erste weitere Halbleiterchip so angeordnet sind, dass ihre jeweiligen Rückseitenkontakte (8a, 8b) dem leitfähigen Substrat zugewandt sind, wobei das leitfähige Substrat eine elektrische Verbindung zwischen dem Rückseitenkontakt (8a) des Halbleiterchips und dem Rückseitenkontakt (8b) des ersten weiteren Halbleiterchips bildet.

10. Halbleitervorrichtung (1) nach einem der vorherigen Ansprüche, wobei die erste Region (4a), die zweite Region (4b) und die dritte Region (4c) zusammen einen BJT bilden.

11. Halbleitervorrichtung (1) nach einem der vorherigen Ansprüche, wobei die zweite Region (4b) eine erste Teilregion (10a) und eine zweite Teilregion (10b) umfasst, wobei die erste Teilregion (10a) mit Bezug auf die zweite Teilregion (10b) relativ schwach dotiert ist, wobei die erste Region (4a) und die dritte Region (4c) neben der ersten Teilregion (10a) angeordnet und durch die erste Teilregion (10a) von der zweiten Teilregion (10b) beabstandet sind und wobei die vierte Region (4d) neben der zweiten Teilregion (10b) angeordnet und durch die zweite Teilregion (10b) von der ersten Teilregion (10a) beabstandet ist; und/oder
wobei die einzelne weitere Region (7) eine erste weitere Teilregion (11a) und eine zweite weitere Teilregion (11b) umfasst, wobei die erste weitere Teilregion (11a) mit Bezug auf die zweite weitere Teilregion (11b) relativ schwach dotiert ist, wobei die zweite weitere Region (6b) und die vierte weitere Region (6d) neben der ersten weiteren Teilregion (11a) angeordnet und durch die erste weitere Teilregion (11a) von der zweiten weiteren Teilregion (11b) beabstandet sind und wobei die fünfte weitere Region (6e) neben der zweiten weiteren Teilregion (11b) angeordnet und durch die zweite weitere Teilregion (11b) von der ersten weiteren Teilregion (11a) beabstandet ist.

12. Halbleitervorrichtung (1) nach einem der vorherigen Ansprüche,
wobei die Regionen, die der elektronischen Komponente (3) entsprechen, und/oder gegebenenfalls die weiteren Regionen, die der elektronischen Einheit (5) entsprechen, ionenimplantierte Regionen sind.

13. Halbleitervorrichtung (1) nach einem der vorherigen Ansprüche, wobei der Halbleiterchip und/oder gegebenenfalls der erste weitere Halbleiterchip und/oder der zweite weitere Halbleiterchip auf einer von auf Silicium, Si, Siliciumcarbid, SiC, Galliumnitrid, GaN, und Galliumarsenid, GaAs, beruhenden Techniken basieren.

14. Vorrichtung zum Schutz bei elektrostatischer Entladung, ESD-Schutzvorrichtung (20), die dazu konfiguriert ist, mit einer elektronischen Schaltung (30) elektrisch verbunden zu werden und die elektronische Schaltung (30) vor ESD-Ereignissen zu schützen,
wobei die ESD-Schutzvorrichtung (20) eine oder mehrere Halbleitervorrichtungen (1) nach einem der vorherigen Ansprüche umfasst und
wobei die ESD-Schutzvorrichtung (20) vorzugsweise eine Vorrichtung in einem Gehäuse ist.

15. Vorrichtung, die eine auf einem Halbleiterchip integrierte elektronische Schaltung und eine oder mehrere Halbleitervorrichtungen (1) nach einem der Ansprüche 1-13 umfasst, wobei die eine oder die mehreren Halbleitervorrichtungen (1) auf dem Halbleiterchip integriert und mit der elektronischen Schaltung elektrisch verbunden sind, um die elektronische Schaltung vor ESD-Ereignissen zu schützen,
wobei die Vorrichtung vorzugsweise eine Vorrichtung in einem Gehäuse ist.

## Revendications

1. Dispositif semi-conducteur (1) comprenant une puce semi-conductrice (D1) ayant un composant électronique (3) intégré dessus, le composant électronique (3) comprenant des régions dans la puce semi-conductrice (D1), les régions comprenant :
une première région (4a) d'un premier type de charge conçue pour être électriquement connectée à une première borne de dispositif (2a) ;
une deuxième région (4b) d'un deuxième type de charge agencée adjacente à et formant une première jonction PN avec la première région (4a) ;
une troisième région (4c) du premier type de charge agencée adjacente à et formant une deuxième jonction PN avec la deuxième région (4b), la troisième région (4c) étant espacée de la première région (4a) par ladite deuxième région (4b) et étant conçue pour être électriquement connectée à une deuxième borne de dispositif (2b) ; et
une quatrième région (4d) du premier type de charge agencée adjacente à et formant une troisième jonction PN avec la deuxième région (4b), la quatrième région (4d) étant espacée de la première région (4a) et la troisième région (4c) par ladite deuxième région (4b),
dans lequel le dispositif semi-conducteur (1) comprend en outre une unité électronique (5) conçue pour être électriquement connectée entre la première borne de dispositif (2a), la deuxième borne de dispositif (2b) et la quatrième région (4d), dans lequel, pendant le fonctionnement, l'unité électronique (5) est conçue pour fournir un premier chemin de courant ou un deuxième chemin de courant en fonction d'une polarité d'une tension entre la première borne de dispositif (2a) et la deuxième borne de dispositif (2b),
**caractérisé en ce que** soit
le premier type de charge correspond à un dopage de type n, et le premier chemin de courant et le deuxième chemin de courant s'étendent de la première borne de dispositif (2a) et la deuxième borne de dispositif (2b), respectivement, en direction de la quatrième région (4d), soit
le premier type de charge correspond à un dopage de type p, et le premier chemin de courant et le deuxième chemin de courant s'étendent de la quatrième région (4d) vers la première borne de dispositif (2a) et la deuxième borne de dispositif (2b), respectivement.

2. Dispositif semi-conducteur (1) selon la revendication 1, dans lequel l'unité électronique (5) comprend d'autres régions comprises dans la puce semi-conductrice (D1) ou une ou plusieurs autres puces semi-conductrices sur lesquelles ladite unité électronique (5) est intégrée, les autres régions comprenant :
une première autre région (6a) du premier type de charge ;
une deuxième autre région (6b) du deuxième type de charge agencée adjacente à et formant une première autre jonction PN avec la première autre région (6a), la deuxième autre région étant conçue pour être électriquement connectée à la première borne de dispositif (2a) ;
une troisième autre région (6c) du premier type de charge ; et
une quatrième autre région (6d) du deuxième type de charge agencée adjacente à et formant une deuxième autre jonction PN avec la troisième autre région (6c), la quatrième autre région étant conçue pour être électriquement connectée à la deuxième borne de dispositif (2b),
dans lequel la première autre région (6a) et la deuxième autre région (6b) sont comprises dans la puce semi-conductrice (D1) ou dans une première autre puce semi-conductrice, et dans lequel la troisième autre région (6c) et la quatrième autre région (6d) sont comprises dans la puce semi-conductrice (D1), la première autre puce semi-conductrice ou une deuxième autre puce semi-conductrice,
dans lequel le premier chemin de courant s'étend entre la première autre région (6a) et la deuxième autre région (6b), et dans lequel le deuxième chemin de courant s'étend entre la troisième autre région (6c) et la quatrième autre région (6d).

3. Dispositif semi-conducteur (1) selon la revendication 2, dans lequel la première autre région (6a) et la troisième autre région (6c) sont chacune électriquement connectée à la quatrième région (4d),
dans lequel la première autre région (6d) et la deuxième autre région (6b) ensemble forment une première diode, et dans lequel la troisième autre région (6c) et la quatrième autre région (6d) ensemble forment une deuxième diode.

4. Dispositif semi-conducteur (1) selon la revendication 2, dans la mesure où les première à quatrième autres régions (6a-6d) sont toutes comprises dans la puce semi-conductrice (D1) ou sur la première autre puce semi-conductrice, dans lequel la première autre région (6a) et la troisième autre région (6c) sont agencées adjacentes et forment une unique autre région (7).

5. Dispositif semi-conducteur selon la revendication 4, dans lequel l'unique autre région (7) est électriquement connectée à la quatrième région (4d), et
dans lequel la première autre région (6a), la deuxième autre région (6b), la troisième autre région (6c) et la quatrième autre région (6d) forment ensemble un transistor bipolaire à jonction, BJT.

6. Dispositif semi-conducteur (1) selon la revendication 4, dans lequel les autres régions comprennent en outre une cinquième autre région (6e) du deuxième type de charge agencée adjacente à et formant une troisième autre jonction PN avec l'unique autre région (7), la cinquième autre région (6e) étant électriquement connectée à la quatrième région (4d) et étant comprise dans la puce semi-conductrice ou la première autre puce semi-conductrice,
dans lequel le premier chemin de courant et le deuxième chemin de courant s'étendent en plus chacun à travers la cinquième autre région (6e).

7. Dispositif semi-conducteur (1) selon la revendication 6, dans la mesure où les première à cinquième régions (6a-6e) sont toutes comprises dans la puce semi-conductrice, dans lequel la quatrième région (4d) est agencée adjacente à et forme une jonction PN intermédiaire avec la cinquième autre région (6e).

8. Dispositif semi-conducteur (1) selon la revendication 7, dans lequel la cinquième autre région (6e) et la deuxième région (4b) sont agencées de manière adjacente pour former ensemble une région contiguë, ou dans lequel la quatrième région (4d) et l'autre région unique (7) sont agencées de manière adjacente pour former ensemble une région contiguë.

9. Dispositif semi-conducteur (1) selon la revendication 6, dans la mesure où les première à cinquième autres régions (6a-6e) sont toutes comprises dans la première autre puce semi-conductrice, dans lequel le semi-conducteur comprend un premier contact arrière (8a) électriquement connecté à la quatrième région (4d), et dans lequel la première autre puce semi-conductrice comprend un deuxième contact arrière (8b) électriquement connecté à la cinquième autre région (6e),
dans lequel le dispositif semi-conducteur (1) comprend en outre un substrat conducteur (9), la puce semi-conductrice et la première autre puce semi-conductrice étant agencées avec leurs contacts arrière respectifs (8a, 8b) faisant face au substrat conducteur, dans lequel le substrat conducteur forme une connexion électrique entre le contact arrière (8a) de la puce semi-conductrice et le contact arrière (8b) de la première autre puce semi-conductrice.

10. Dispositif semi-conducteur (1) selon l'une quelconque des revendications précédentes, dans lequel la première région (4a), la deuxième région (4b) et la troisième région (4c) ensemble forment un BJT.

11. Dispositif semi-conducteur (1) selon l'une quelconque des revendications précédentes, dans lequel la deuxième région (4b) comprend une première sous-région (10a) et une deuxième sous-région (10b), la première sous-région (10a) étant relativement moins dopée que la deuxième sous-région (10b), la première région (4a) et la troisième région (4c) étant agencées adjacentes à la première sous-région (10a) et étant espacées de la deuxième sous-région (10b) par ladite première sous-région (10a), et la quatrième région (4d) étant agencée adjacente à la deuxième sous-région (10b) et étant espacée de la première sous-région (10a) par ladite deuxième sous-région (10b) ; et/ou
dans lequel l'autre région unique (7) comprend une première autre sous-région (11a) et une deuxième autre sous-région (11b), la première autre sous-région (11a) étant relativement moins dopée que la deuxième autre sous-région (11b), la deuxième autre région (6b) et la quatrième autre région (6d) étant agencées adjacentes à la première autre sous-région (11a) et étant espacées de la deuxième autre sous-région (11b) par ladite première autre sous-région (11a), et la cinquième autre région (6e) étant agencée adjacente à la deuxième autre sous-région (11b) et étant espacée de la première autre sous-région (11a) par ladite deuxième autre sous-région (11b).

12. Dispositif semi-conducteur (1) selon l'une quelconque des revendications précédentes, dans lequel les régions correspondant au composant électronique (3) et/ou, le cas échéant, les autres régions correspondant à l'unité électronique (5) sont des régions à implantation d'ions.

13. Dispositif semi-conducteur (1) selon l'une quelconque des revendications précédentes, dans lequel la puce semi-conductrice et/ou, le cas échéant, la première autre puce semi-conductrice et/ou la deuxième autre puce semi-conductrice sont basées sur l'une d'une technologie au silicium, Si, au carbure de silicium, SiC, au nitrure de gallium, GaN, et à l'arséniure de gallium, GaAs.

14. Dispositif de protection contre les décharges électrostatiques, ESD (20) conçu pour être électriquement connecté à un circuit électronique (30) et pour protéger ledit circuit électronique (30) contre des événements d'ESD,
dans lequel le dispositif de protection contre les ESD (20) comprend un ou plusieurs dispositifs semi-conducteurs (1) tels que définis dans l'une quelconque des revendications précédentes, et
dans lequel le dispositif de protection contre les ESD (20) est de préférence un dispositif encapsulé.

15. Dispositif comprenant un circuit électronique intégré sur une puce semi-conductrice, et un ou plusieurs dispositifs semi-conducteurs (1) tels que définis dans l'une quelconque des revendications 1 à 13, les un ou plusieurs dispositifs semi-conducteurs (1) étant intégrés sur la puce semi-conductrice et étant électriquement connectés au circuit électronique pour protéger ledit circuit électronique contre des événements d'ESD,
dans lequel le dispositif est de préférence un dispositif encapsulé.
